Europäisches Patentamt

European Patent Office

Office européen des brevets

(11) Publication number: **0 097 498**
**B1**

(12) **EUROPEAN PATENT SPECIFICATION**

(45) Date of publication of patent specification: **08.01.86**

(21) Application number: **83303504.1**

(22) Date of filing: **17.06.83**

(51) Int. Cl.⁴: **H 03 K 17/96**

(54) **Touch sensing device.**

(30) Priority: **18.06.82 JP 105665/82**

(43) Date of publication of application:
**04.01.84 Bulletin 84/01**

(45) Publication of the grant of the patent:
**08.01.86 Bulletin 86/02**

(84) Designated Contracting States:
**DE FR GB IT NL**

(56) References cited:
**EP-A-0 078 676**
**US-A-4 110 749**
**US-A-4 175 239**
**US-A-4 290 052**

(73) Proprietor: **FUJITSU LIMITED**
**1015, Kamikodanaka Nakahara-ku**
**Kawasaki-shi Kanagawa 211 (JP)**

(72) Inventor: **Yoshikawa, Kazuo**
**Fujitsu Ltd. Patent Dpt. 1015, Kamikodanaka**
**Nakahara-ku Kawasaki-shi Kanagawa 211 (JP)**
Inventor: **Yamaguchi, Hisashi**
**Fujitsu Ltd. Patent Dpt. 1015, Kamikodanaka**
**Nakahara-ku Kawasaki-shi Kanagawa 211 (JP)**
Inventor: **Asano, Toru**
**Fujitsu Ltd. Patent Dpt. 1015, Kamikodanaka**
**Nakahara-ku Kawasaki-shi Kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

This invention relates to a touch sensing device of the type defined in the precharacterising portion of Claim 1. An example of such a device is disclosed in US—A—4110749.

Such a touch sensing device can be provided as a see-through type finger touch sensing device on a display screen used for inputing data, corresponding to an area designated by finger touch, to a computer system.

As a man-machine interface unit there has been proposed a see-through type touch keyboard which is mounted over a display screen of a display unit and which is used for inputting data to a computer system corresponding to an area designated by finger touch on the keyboard. For a touch keyboard of this kind it is important that touch condition is accurately detected and various methods have been proposed for achieving this.

In one proposed method a change of capacitance between a touch sensing electrode and ground, caused by a finger touching the electrode, is measured by utilizing a resonance phenomenon in a resonant circuit. This method is explained in detail in EP—A1—78676, which forms part of the state of the art according to Article 54(3) EPC, by the present applicant.

A touch sensing method utilizing a resonant circuit has the merit that the touch condition can be detected with a large ON-OFF ratio, but can have the demerit that erroneous operation may be caused by contamination of the touch surface. Moreover, in case in which a large scale touch panel is provided, capacitance between adjacent electrodes is increased and thereby detection sensitivity may be decreased.

According to the present invention there is provided a touch sensing device, comprising a plurality of touch sensing electrodes and a touch sensing circuit to which the touch sensing electrodes are sequentially and selectively connected in turn, the touch sensing circuit comprising an oscillator operable to supply an AC signal to the selected touch sensing electrode connected to the oscillator, characterized in that the device further comprises a buffer circuit operable to provide an AC signal corresponding to the AC signal supplied from the oscillator to the selected touch electrode but isolated therefrom and operable to supply the corresponding AC signal to the non-selected touch sensing electrodes, whereby the non-selected touch sensing electrodes are clamped to substantially the same potential as that of the selected electrode.

An embodiment of this invention can provide for the prevention or mitigation of problems such as erroneous sensing arising from moisture and contamination of a touch panel surface of an electrostatic capacitance detection type touch sensing device.

An embodiment of this invention can provide for highly reliable touch sensing operations and can make possible the provision of highly sensitive detecting operations for a large scale touch panel.

Briefly, a touch sensing device embodying this invention has a plurality of touch sensing electrodes, disposed in correspondence to respective sensing locations, a touch sensing circuit to which relevant touch sensing electrodes are sequentially and selectively connected by means of a change-over or switching operation, the touch sensing circuit providing an oscillation circuit which supplies an AC signal to a selected touch sensing electrode, and further comprises a buffer circuit which isolates a voltage corresponding to an AC signal of an output of the oscillation circuit from selected touch sensing electrodes and supplies it to non-selected touch electrodes, impedance between those non-selected touch sensing electrodes and selected touch sensing electrodes being thereby rendered substantially negligible.

Reference is made, by way of example, to the accompanying drawings:—

Fig. 1 is a schematic block diagram for assistance in explaining operational principles of a touch sensing device to which an embodiment of the pesent invention is applied,

Fig. 2 is a schematic block diagram illustrating in more detail a touch sensing device embodying the present invention; and

Fig. 3 is a schematic block diagram illustrating another embodiment of this invention.

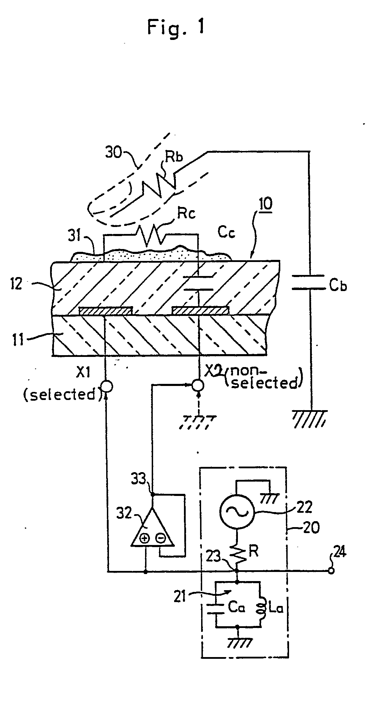

In Fig. 1, a touch panel 10 includes a pair of transparent touch sensing electrodes X1 and X2, arranged adjacently on a transparent substrate 11, and a cover consisting of a transparent insulation film 12 placed thereon.

In a case in which touch electrode X1 is selected, a sensing circuit 20 is connected to the pertinent (selected) touch electrode.

The sensing circuit 20 comprises in principle, a parallel resonance circuit 21 having an inductance La and a capacitance Ca, an AC oscillator 22 and a resistance element R which connects an output of the oscillator to the resonator or resonance circuit 21. The resonator 21 is usually designed to have a resonant characteristic tuned to the oscillation frequency of oscillator 22, for example 12.5 kHz, and to exhibit a maximum impedance (ideally, infinity) in the resonant condition.

If the pertinent touch electrode is not being touched, when touch electrode X1 is selected as explained above, a signal of an OFF level, which is substantially equivalent to the output of oscillator 22, appears at an output terminal 24 connected to a connecting point 23 of the oscillator 22 and the resonator 21.

On the other hand, if finger 30 touches the touch electrode X1 under such conditions, a resistance Rb and a capacitance Cb attributable to the human body are effectively linked to the selected touch electrode X1. Therefore, the resonant condition of resonator 21 is destroyed and signal level at the connecting point 23, namely the level appearing at the output terminal 24, drops to an ON level.

The touch sensing operation is reliable because the ratio of the OFF state signal level to the ON state signal level is large.

Let it be supposed that a contaminating substance 31, such as water or sweat, exists in such a manner as to ride over or cross between the touch electrodes X1 and X2, as shown in Fig. 1. This contaminating substance 31 bridges the selected electrode X1 to the non-selected electrode X2 with an equivalent resistance $R_c$. In this case, if the non-selected electrode is clamped (as indicated by a broken line in Fig. 1) to ground, inductive interference arising because of capacitance between the adjacent electrodes can be prevented, but a new problem arises. Namely, a path extending to the non-selected electrode X2, passing through the equivalent resistance Rc of the contaminating substance 31 and the equivalent capacitance Cc of the insulation film 12, gives rise to the effect on the selected electrode X1 which is as if the path which is established by a finger touch, passing through a resistance Rb and a capacitance Cb of the human body, were established. As a result, a pseudo-touch condition may be sensed in relation to electrode X1 even if there is no finger touching the panel.

In embodiments of the present invention steps are taken to prevent or mitigate such erroneous operations, resulting from contamination as described above. Basically, those steps involve clamping non-selected touch sensing electrodes to a voltage substantially of the same phase and the same level as that of the selected touch sensing electrodes. .

In order to realize such clamping an output of the oscillator 22 is supplied from the connecting point 23 (the connecting point of the oscillator 22 and the resonator 21) to the non-selected electrode X2 through a buffer circuit 32, for separating the non-selected electrode X2 and point 23, as shown in Fig. 1. The buffer circuit 32 comprises a voltage follower type operational amplifier and is structured as a non-inverting type amplifier having a high input impedance and low output impedance characteristic wherein voltage gain is adjusted to be substantially unity by connecting the minus input terminal (−) of the amplifier to its input terminal 33.

Thus, a voltage waveform appearing at the output terminal 33 of the buffer circuit 32 is of substantially the same phase and the same level as the voltage waveform sent from the connecting point 23 for input to the selected electrode X1. As a result, the selected touch sensing electrode X1 and the adjacent non-selected touch sensing electrode X2 are always sustained substantially at the same signal voltage, and accordingly impedance between these selected and non-selected electrodes can substantially be neglected. Therefore, operational problems no longer arise even if moisture or other contamination is present on the surface of touch panel.

On the other hand, considering such touch sensing devices, as panel size increases, electrode capacitance between a selected touch electrode and non-selected touch electrodes increases. If the non-selected touch electrodes are clamped to ground, such interelectrode capacitance is simply connected in parallel to the resonator 21. Therefore, there is problem in that as such interelectrode capacitance, between selected and non-selected electrodes, increases the change in touch electrode capacitance brought about by the addition of the capacitance of the human body when a finger touches an electrode is relatively smaller, resulting in a decrease in detecting sensitivity.

However, in embodiments of this invention, both selected and non-selected electrodes are maintained at the same potential and therefore such interelectrode capacitance can be neglected and accordingly the above problem of reduction of detecting sensitivity with increased panel size can be effectively solved.

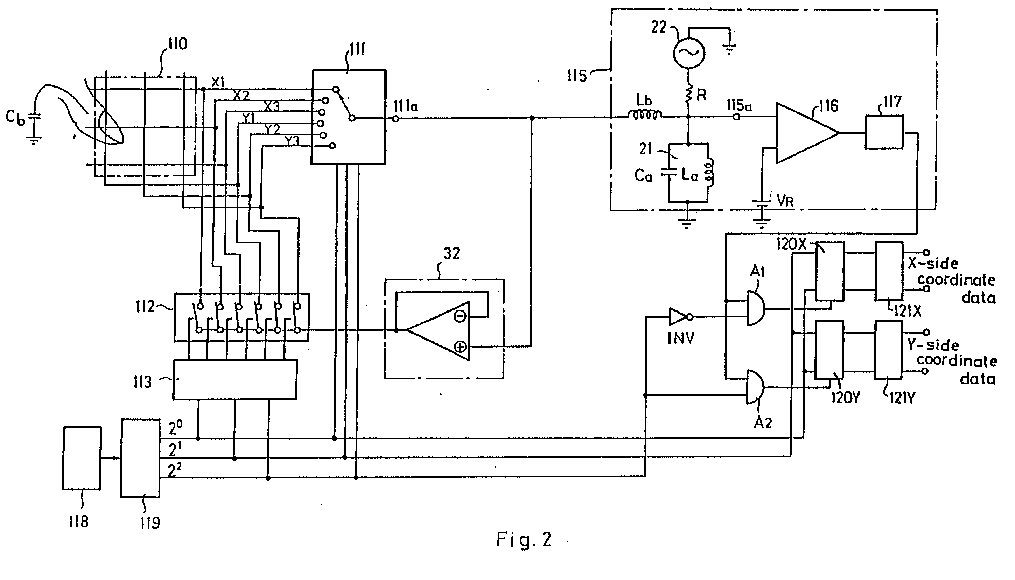

Fig. 2 is a schematic block diagram illustrating more practically the circuit configuration of an embodiment of this invention.

In Fig. 2, a touch panel 110 has respective pluralities of X and Y sensing electrodes (a 3 × 3 array of sensing electrodes is shown for convenience) X1 to X3, Y1 to Y3 connected to a multiplexer 111 and an analog switch array 112.

An output terminal 111a of the multiplexer 111 is connected to a sensing circuit 115 utilizing a parallel-series composite type resonator and an output terminal 115a of the resonator 115 is followed by a comparator 116, which compares the output volage level of the resonator with a reference voltage level $V_R$, and a smoothing circuit 117.

The sensing circuit 115 has coils La and Lb, a capacitor Ca and a resistor R. The capacitor Ca and coil La form a parallel resonator 21, whilst a capacitor Cb, representing the body capacitance of an operator, and the coil Lb form a series resonator. An AC signal of constant frequency (for example, 12.5 kHz) is supplied from oscillator 22. The parallel resonator and the series resonator are designed so as to be tuned to the oscillation frequency of the oscillator 22.

The multiplexer 111 is sequentially switched so that the sensing electrodes are connected in turn to the sensing circuit, only one sensing electrode being connected to the sensing circuit 115 at a time. A clock signal generator 118 and a 3-bit counter 119 generate address signals governing the sequential switching of the multiplexer; the multiplexer 111 having a decoding function so that the sensing electrodes are connected one by one to the sensing circuit 115 in accordance with the state of the address signal output of the counter 119.

Address signals from the counter 119 are also input to a decoder 113. The address signals are decoded by the decoder 113 and as a result the analog switch array 112 is controlled. The analogs switch array 112 operates so as to connect all non-selected sensing electrodes to the output of buffer circuit 32 (that is, all electrodes except only the one selected sensing electrode which is connected to the sensing circuit 115 through the multiplexer 111).

This buffer circuit 32 comprises, as explained previously, a non-inverting type amplifier which provides a voltage gain of about 1 and has high input impedance and low output impedance, having the minus (−) input terminal of a voltage follower type operational amplifier connected to its output terminal.

The input side of buffer circuit 32 is connected to the output terminal 111a side of the multiplexer 111 and thereby supplies to the switch array 112 a voltage same as that supplied to the selected touch electrode, with the same phase.

With such a panel structure, for example, when the touch sensing electrode X1 i selected, an AC signal provided by the oscillator 22 is supplied to the touch sensing electrode X1 through the multiplexer 111. On the other hand, the AC signal output of the oscillator 22 is supplied to all non-selected touch sensing electrodes $X_2$ to $Y_3$ (all electrodes except electrode X1) through the buffer circuit 32. The buffer circuit 32 comprises a non-inverting type amplifier which provides a voltage gain of about 1 and therefore the AC signal voltage supplied to the touch sensing electrode X1 and the AC signal voltage supplied to the non-selected touch sensing electrodes $X_2$—$Y_3$ are the same in phase and voltage. Namely, the voltage of the non-selected touch sensing electrodes $X_2$, $X_3$ and $Y_1$—$Y_3$ follows the voltage of the selected touch sensing electrode $X_1$ in phase and level. As a result, hardly any current flows between the selected touch sensing electrode $X_1$ and non-selected touch sensing electrodes, and accordingly impedance between the selected touch sensing electrode $X_1$ and the non-selected touch sensing electrodes can be substantially neglected. Further, when touch sensing electrodes other than electrode $X_1$ are connected sequentially and selectively to the resonator 21 by the multiplexer 111, the impedance between the sequentially selected touch sensing electrode and the non-selected touch sensing electrodes is always substantially negligible.

Since input impedance of the buffer circuit 32 is sufficiently greater than the resonant impedance of the resonator 21, electrostatic capacitance changes relating to touch sensing electrodes, arising when particular areas of the touch panel 110 are designated by finger touch, can be sensed without problems as a change of voltage at the connecting point of the impedance element R and resonator 21. Moreover since output impedance of the buffer circuit 32 is almost zero when touch sensing electrodes corresponding to a designated touch area are brought into the non-selected condition by the analog multiplexer 111, the AC signal voltage supplied to those touch sensing electrodes is substantially exactly the same as the AC signal voltage supplied to the other touch sensing electrodes.

As buffer circuit 32, an integrated operational amplifier circuit which is commercially available under the type designation LM—310 may be used. This amplifier circuit has an input impedance of $10^{12}$ohms and an output impedance of 0.75 ohm and provides a voltage gain of 0.999 at a frequency of 10 kHz.

The output comparator 116, which receives a sense signal from the sensing circuit output 115a, is connected through the smoothing circuit 117 to one input terminal of each of a pair of AND gates A1 and A2. AND gate A1 outputs a touch signal relating to an X sensing electrode when a signal obtained by inverting a bit of the address signal output from the 3-bit counter 119, by means of an inverter INV, matches the sense signal. AND gate A2 outputs, in the same way, a touch signal relating to a Y sensing electrode. The output signals of AND gates A1 and A2 are respectively sent to registers 120X, 120Y and temporarily stored therein as address signals at the time when touch signals are generated. The data stored in these registers 120X and 120Y is read by output registers 121X, 121Y, when one scanning cycle or period for all the X and Y sensing electrodes is completed, for sending to a computer system as address information indicating a finger-touch electrode location.

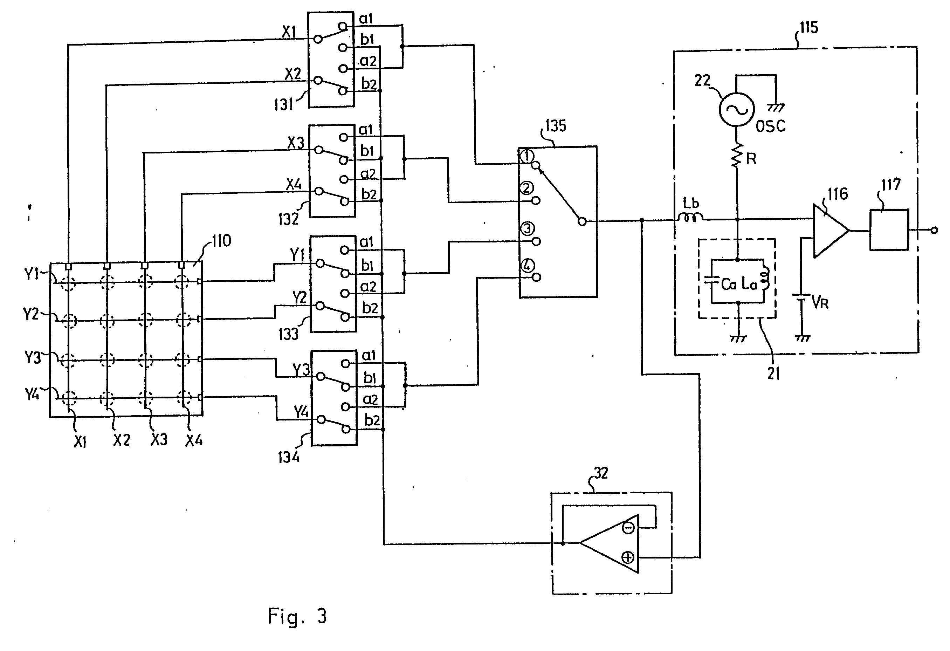

Fig. 3 illustrates another embodiment of the present invention in which elements similar to those of Fig. 2 are given the same reference signs.

In Fig. 3, the touch panel 110 has eight touch sensing electrodes $X_1$—$X_4$ and $Y_1$—$Y_4$. The X and Y electrodes are respectively divided into blocks of two electrodes each, and are connected to four analog switches 131—134. Each analog switch has the two pairs of input terminals a1, a2 and b1, b2. One pair of input terminals $a_1$, $a_2$ of each analog switch is connected to a respective one of four output terminals 1—4 of an analog multiplexer 135 which is connected to the sensing circuit 115. The terminals of each pair are commonly connected. In addition, the other pairs of input terminals b1, b2 of the analog switches are connected to the output of the buffer circuit 32. Namely, in the embodiment of Fig. 3, connection of selected touch electrodes to the sensing circuit and connection of non-selected touch electrodes to the buffer circuit are effected through analog switches 131—134. If the eight *a1* side input terminals of the analog switches 131—134 were connected in common, the analog multiplexer might theoretically be omitted. However, in case a number of electrodes to be selected increases, such a common connection would bring about the addition of an unwanted floating capacitance to a selected touch electrodes and a resultant reduction in detection sensivity might be caused. It is very effective for preventing such reduction in detection sensivity to provide an analog multiplexer 135, as described above, which switches the sensing circuit in correspondence to a plurality of electrode blocks by grouping the touch sensing electrodes.

As will be understood from the above description, in embodiments of this invention, adverse effects of inter-electrode capacitance between touch sensing electrodes and operational problems due to moisture and contamination can be eliminated. Accordingly, a highly sensitive and reliable touch sensing device can be provided which can have a large size touch panel.

An embodiment of this invention can provide a see-through type finger touch sensing device which has a resonator and an oscillator, for supplying an AC signal to the resonator, as a sensing circuit. A buffer circuit, which isolates an output of the oscillator from the selected touch electrodes and supplies it to all the remaining non-selected touch electrodes when such sensing circuits are sequentially connected to the plurality of touch sensing electrodes, is additionally provided. Thereby, selected touch electrodes and non-selected touch electrodes are maintained at voltages of the same phase and the same level and the effects of inter-electrode impedance are substantially negligible.

It will be understood that the present invention can be applied to touch sensing devices intended to sense the touch of an implement, rather than the human finger.

## Claims

1. A touch sensing device, comprising a plurality of touch sensing electrodes and a touch sensing circuit to which touch sensing electrodes are sequentially and selectively connected in turn, the touch sensing circuit comprising an oscillator operable to supply an AC signal to the selected touch sensing electrode connected to the oscillator, characterized in that the device further comprises a buffer circuit operable to provide an AC signal corresponding to the AC signal supplied from the oscillator to the selected touch electrode but isolated therefrom and operable to supply the corresponding AC signal to the non-selected touch sensing electrodes, whereby the non-selected touch sensing electrodes are clamped to substantially the same potential as that of the selected electrode.

2. A touch sensing device as claimed in claim 1, wherein the buffer circuit is composed of a non-inverting type amplifier having a voltage gain of about unity, a high input impedance and a low output impedance.

## Patentansprüche

1. Berührungsempfindliche Vorrichtung mit einer Vielzahl von berührungsempfindlichen Elektroden und einem berührungsempfindlichen Schaltkreis, mit dem die berührungsempfindlichen Elektroden sequenziell und wahlweise nacheinander verbunden werden, wobei der berührungsempfindliche Schaltkreis einen Oszillator umfaßt, der im Betrieb ein Wechselstromsignal an die ausgewählte berührungsempfindliche Elektrode liefert, die mit dem Oszillator verbunden ist, dadurch gekennzeichnet, daß die Vorrichtung ferner eine Pufferschaltung umfaßt, die im Betrieb ein Wechselstromsignal liefert, welches dem von dem Oszillator an die ausgewählte berührungsempfindliche Elektrode gelieferten Wechselstromsignal entspricht, von dieser jedoch isoliert ist, und die im Betrieb ein entsprechendes Wechselstromsignal an die nicht ausgewählten berührungsempfindlichen Elektroden liefert, wodurch die nicht ausgewählten berührungsempfindlichen Elektroden an im wesentlichen dasselbe Potential wie das der ausgewählten Elektrode geklammert werden.

2. Berührungsempfindliche Vorrichtung nach Anspruch 1, bei welcher der Pufferschaltkreis aus einem Verstärker vom nicht invertierenden Typ besteht, der eine Spanungsverstärkung von etwa einer Einheit, eine hohe Eingangsimpedanz und eine niedridge Ausgangsimpedanz hat.

## Revendications

1. Dispositif de détection de contact, comprenant plusieurs électrodes de détection de contact et un circuit de détection de contact auquel les électrodes de détection de contact sont séquentiellement et sélectivement connectées tour à tour, le circuit de détection de contact comprenant un oscillateur ayant pour fonction de délivrer un signal de courant alternatif à l'électrode de détection de contact sélectionnée qui est connectée à l'oscillateur, caractérisé en ce que le dispositif comprend en outre un circuit tampon ayant pour fonction de produire un signal de courant alternatif correspondant au signal de courant alternatif délivré par l'oscillateur à l'électrode de contact sélectionnée, mais isolé de celle-ci et ayant pour fonction de délivrer le signal de courant alternatif correspondant aux électrodes de détection de contact non sélectionnées, si bien que les électrodes de détection de contact non sélectionnées sont verrouillées sur sensiblement le même potentiel que l'électrode sélectionnée.

2. Dispositif de détection de contact selon la revendication 1, où le circuit tampon est constitué d'un amplificateur du type non-inversion posse-1dant un gain de tension approximativement égal à l'unité, une impédance d'entrée élevée et une impédance de sortie basse.

0 097 498

Fig. 1

1

Fig. 2

0 097 498

115

117

116

$V_R$

OSC

R

21

Ca La

22

Lb

32

135

① ② ③ ④

131 — a1 b1 a2 b2 — X1 X2

132 — a1 b1 a2 b2 — X3 X4

133 — a1 b1 a2 b2 — Y1 Y2

134 — a1 b1 a2 b2 — Y3 Y4

110

X4 X3 X2 X1

Y1 Y2 Y3 Y4

Fig. 3